# EUROPEAN PATENT APPLICATION

(11) **EP 4 615 196 A1**
(43) Date of publication of application: **10.09.2025**
(21) Application number: 24893169.3
(22) Date of filing: 29.10.2024
(51) Int. Cl.: H10F 77/20

(54) **SOLAR CELL AND SOLAR MODULE**

(30) Priority: 21.11.2023 CN 202323133465 U
(71) Applicant: Longi Green Energy Technology Co., Ltd., Xi'an, Shaanxi 710100 (CN)
(72) Inventor: TONG, Hongbo, Shaanxi 710100 (CN); LI, Zhenguo, Shaanxi 710100 (CN); DENG, Shengjie, Shaanxi 710100 (CN); YU, Long, Shaanxi 710100 (CN); JIN, Yupeng, Shaanxi 710100 (CN)
(74) Representative: Pfenning, Meinig & Partner mbB
(86) International application number: PCT/CN2024/127992
(87) International publication number: WO 2025/108011

(57) **Abstract**

The present application discloses a solar cell and a solar module, and relates to the technical field of solar cells, to solve the problem of high manufacturing costs of a solar cell caused by high manufacturing costs of a busbar. The solar cell includes busbars and collector electrodes formed on a solar cell body. A plurality of pads are arranged on the busbars at intervals in a first direction. For each of at least some busbars, in a direction from a preset point on the busbar to any one of the pads adjacent to the preset point on the busbar, a width of the busbar gradually increases. The preset point is any point between any two adjacent pads on the busbar on which the preset point is located, and a width direction of the busbar is consistent with a second direction. For each of the at least some busbars, Sz≥2×n×Sx, and n is an integer greater than or equal to 1. At least one busbar located between the preset point on the busbar and any one of the pads adjacent to the preset point on the busbar is defined as a first busbar, and Sx represents a cross-sectional area, in the first direction, of any one of the collector electrodes intersecting with the first busbar. For an n^{th} collector electrode that intersects with the first busbar starting from the preset point on the busbar and in a direction from the preset point to the any one of the pads, Sz represents a cross-sectional area, in the second direction, of the first busbar at a location at which the first busbar intersects with the n^{th} collector electrode.

## Description

### TECHNICAL FIELD

The present application relates to the technical field of solar cells, and in particular, to a solar cell and a solar module.

### BACKGROUND

A solar cell is a semiconductor device that can convert solar energy into electric energy. Specifically, when the solar cell is illuminated, a semiconductor substrate included in the solar cell absorbs photons and generates electron and hole pairs. The electron and hole pairs are separated under the action of a built-in electric field in a PN junction, are led out through an emitter and a back field of the solar cell respectively, and are finally collected by an electrode structure arranged on the semiconductor substrate.

The electrode structure generally includes a busbar, a finger, and a pad arranged on the busbar. Currently, the busbar has a uniform width. In a case that the width of the busbar away from the pad is consistent with the width of the busbar at a position where the pad is arranged, manufacturing costs of the busbar are increased, leading to increased manufacturing costs of the solar cell.

### SUMMARY

An objective of the present application is to provide a solar cell and a solar module, to reduce manufacturing costs of a busbar, so as to reduce manufacturing costs of the solar cell.

To implement the foregoing objective, in a first aspect, the present application provides a solar cell. The solar cell includes: a solar cell body, a plurality of busbars, a plurality of pads, and a plurality of collector electrodes. The plurality of busbars are formed on the solar cell body, extend in a first direction, and are distributed at intervals in a second direction. The first direction is different from the second direction. The plurality of pads are arranged on the busbars at intervals in the first direction. For each of at least one of the plurality of busbars, in a direction from a preset point on the busbar to any one of the pads adjacent to the preset point on the busbar, a width of the busbar gradually increases. The preset point is any point between any two adjacent pads on the busbar on which the preset point is located, and a width direction of the busbar is consistent with a second direction. A direction from the preset point to any one of the pads adjacent to the preset point on the busbar on which the preset point is located is parallel to the first direction. The plurality of collector electrodes are formed on the solar cell body, extend in the second direction, and are distributed at intervals in the first direction. Each of the busbars intersects with a plurality of collector electrodes with a same polarity. For each of the at least one busbars, Sz≥2×n×Sx, and n is an integer greater than or equal to 1. At least one busbar located between the preset point on the busbar and any one of the pads adjacent to the preset point on the busbar is defined as a first busbar, and Sx represents a cross-sectional area, in the first direction, of any one of the collector electrodes intersecting with the first busbar. For an n^{th} collector electrode that intersects with the first busbar starting from the preset point on the busbar and in a direction from the preset point to the any one of the pads, Sz represents a cross-sectional area, in the second direction, of the first busbar at a location at which the first busbar intersects with the n^{th} collector electrode.

In an actual use process, the collector electrode collects carriers generated in a corresponding region of the solar cell body, and the busbar is configured to collect the carriers collected by the collector electrode intersecting with the collector electrode. Then, the busbar conveys the collected carriers to the pad, and the pad conveys the carriers to a solder strip connected to the pad. As a quantity of collector electrodes intersecting with the busbar increases, a current density borne by the busbar continuously increases. Based on this, when a width of the busbar gradually increases in a direction from the preset point to any one of the pads adjacent to the preset point, an ability of the busbar to bear a current density can be improved, so as to improve a current collection effect of the busbar, thereby ensuring performance of the solar cell. It should be understood that a minimum width of the busbar in the present application meets actual operating requirements. In other words, compared with a medium-width busbar in the related art, the busbar in the present application has a more proper width design.

Further, the width of the busbar gradually increases in the direction from the preset point to any one of the pads adjacent to the preset point. In this case, in a case that it is ensured that a region of the busbar connected to the pad operates normally and a dimension of the pad is substantially consistent or consistent with a dimension of a pad in the related art (in other words, a maximum width of the busbar is substantially consistent or consistent with a width of a busbar in the related art, or even less than the width of the busbar in the related art), since the width of the busbar away from the pad gradually decreases, an amount of a slurry used to manufacture the busbar is less than an amount of a slurry used to manufacture a busbar having a same width in the related art. Based on this, manufacturing costs of the busbar can be reduced, thereby reducing manufacturing costs of the solar cell. In addition, compared with a medium-width busbar in the related art, the busbar provided in the present application can further reduce blockage to the front of the solar cell body, so as to improve photoelectric conversion efficiency of the solar cell. Further, since Sz≥2×n×Sx, it can be ensured that the busbar has optimal current conductivity when collecting a current.

In an implementation, Sx is greater than or equal to 75 µm² and less than or equal to 375 µm²; and X1 is greater than or equal to 30 µm and less than or equal to 50 µm, where X1 represents a width of any one of the collector electrodes intersecting with the first busbar, and a width direction of the collector electrode is consistent with the first direction.

In this case, in a case that an ability of the collector electrode to collect carriers is ensured, manufacturing costs of the collector electrode can be reduced, thereby further reducing manufacturing costs of the solar cell.

In an implementation, a width Z1 of the first busbar is greater than or equal to a and less than or equal to b, where a is less than b; a is greater than or equal to 30 µm and less than or equal to 200 µm; and b is greater than or equal to 60 µm and less than or equal to 3 mm.

In a case that the above-mentioned technical solution is adopted, the value of the width of the first busbar can be selected by comprehensively considering the cross-sectional area of the collector electrode intersecting with the first busbar, a height of the first busbar, or other influencing factors. In this case, not only selectivity of the width of the first busbar is increased, but also the application range of the first busbar can be expanded.

In an implementation, for the busbar close to an edge of the solar cell body, the collector electrodes having the same polarity are arranged at intervals in the first direction only on a side of the busbar that faces an adjacent busbar. In this case, manufacturing costs of the collector electrode can be reduced.

The solar cell may further include a lap busbar. One end of the lap busbar is connected to the busbar close to the edge of the solar cell body, and the pad is arranged at the other end of the lap busbar. The lap busbar is located between the busbar close to the edge of the solar cell body and the busbar adjacent to the busbar close to the edge of the solar cell body. In this case, connectivity between the pad and the busbar close to the edge of the solar cell body can be ensured to ensure performance of the solar cell.

In an implementation, at any position in the first direction, a width of the busbar close to the edge of the solar cell body is less than a width of a corresponding region of the adjacent busbar.

In a case that the above-mentioned technical solution is adopted, since the collector electrode intersecting with the busbar is arranged on only one side of the busbar close to the edge of the solar cell body, the width of the busbar can be reduced compared with the width of the corresponding region of the adjacent busbar. Based on this, while the ability of the busbar close to the edge of the solar cell body is ensured, manufacturing costs of the busbar can be reduced, thereby reducing manufacturing costs of the solar cell.

In an implementation, at any position in the first direction, a width of the busbar close to the edge of the solar cell body is 1/2 that of a corresponding region of the adjacent busbar.

In an implementation, a projection of the busbar close to the edge of the solar cell body on the solar cell body includes a trapezoid and/or a triangle.

In a case that the above-mentioned technical solution is adopted, the selectivity is increased in a condition that the cross-sectional area of the busbar close to the edge of the solar cell body meets actual requirements. In this case, the busbar can be adapted to different application scenarios to expand the application range of the solar cell.

In an implementation, a width of the lap busbar is equal to a maximum value of a width of the busbar connected to the lap busbar, and a width direction of the lap busbar is consistent with the first direction.

In a case that the above-mentioned technical solution is adopted, not only the ability of the lap busbar to collect all carriers collected by the collector electrode can be ensured, but also the ability of the lap busbar to transmit the collected current to the pad can be ensured, so as to ensure performance of the solar cell.

In an implementation, the solar cell is a back contact solar cell, and the busbar is an N-region busbar.

In a case that the above-mentioned technical solution is adopted, since the N-region busbar is usually made of silver paste and silver has a high unit price, when the busbar provided by the present application is an N-region busbar of a back contact solar cell, manufacturing costs of the busbar can be reduced while the performance of the busbar is ensured, so as to reduce the manufacturing costs of the solar cell.

In an implementation, the preset point is a central point between any two adjacent pads on the busbar on which the preset point is located.

In a second aspect, the present application further provides a solar module. The solar module includes the solar cell according to the above-mentioned technical solution.

Compared with the related art, the solar module according to the present application has the same beneficial effects as the beneficial effects of the solar cell in the above-mentioned technical solution, and details are not described herein.

### BRIEF DESCRIPTION OF THE DRAWINGS

The accompanying drawings described herein are used to provide a further understanding of the present application, and form part of the present application. Exemplary embodiments of the present application and descriptions thereof are used to explain the present application, and do not constitute any inappropriate limitation to the present application. In the accompanying drawings:
FIG. 1 is a schematic partial structural diagram of a solar cell according to an embodiment of the present application;
FIG. 2 is a schematic sectional view of a collector electrode according to an embodiment of the present application;
FIG. 3 is a schematic sectional view of a busbar according to an embodiment of the present application;
FIG. 4 is a first schematic enlarged view of a partial structure in FIG. 1 according to an embodiment of the present application;
FIG. 5 is a second schematic enlarged view of a partial structure in FIG. 1 according to an embodiment of the present application;
FIG. 6 is a schematic partial structural diagram of a solar cell according to an embodiment of the present application; and
FIG. 7 is a schematic enlarged view of a partial structure in FIG. 6 according to an embodiment of the present application.

Reference signs:
1 - busbar, 10 - first busbar, 2 - pad,
3 - collector electrode, 4 - preset point, 5 - second busbar,
6 - lap busbar, A - first direction, B - second direction.

### DETAILED DESCRIPTION

To make the to-be-solved technical problems, technical solutions, and beneficial effects of the present application clearer, the present application is further described in detail below with reference to accompanying drawings and embodiments. It should be understood that the specific embodiments described herein are merely used to explain the present application but are not intended to limit the present application.

It should be noted that, when an element is referred to as being "fixed on" or "arranged on" another element, the element may be directly on the another element or indirectly on the another element. When an element is referred to as "being connected to" another element, the element may be directly connected to the another element, or may be indirectly connected to the another element.

In addition, terms "first" and "second" are used merely for the purpose of description, and shall not be construed as indicating or implying relative importance or implying a quantity of indicated technical features. Therefore, a feature limited by "first" or "second" may explicitly or implicitly include one or more of the features. In the descriptions of the present application, "a plurality of" means two or more, unless otherwise definitely and specifically limited. Unless otherwise explicitly and specifically limited, "several" means one or more.

In the description of the present application, it should be understood that orientation or position relationships indicated by the terms such as "upper", "lower", "front", "rear", "left", and "right" are based on orientation or position relationships shown in the accompanying drawings, and are used only for ease and brevity of description of the present application, rather than indicating or implying that the mentioned device or element needs to have a particular orientation or needs to be constructed and operated in a particular orientation. Therefore, such terms should not be construed as limiting the present application.

In the descriptions of the present application, it should be noted that, unless otherwise explicitly specified and defined, the terms such as "mounting", "connecting", and "connection" should be understood in a broad sense. For example, they may be a fixed connection, a detachable connection, or an integrated connection; may be a mechanical connection or an electrical connection; and may be a direct connection, an indirect connection through an intermediate medium, internal communication between two elements, or an interaction relationship between two elements. A person of ordinary skill in the art may understand the specific meanings of the foregoing terms in the present application according to specific situations.

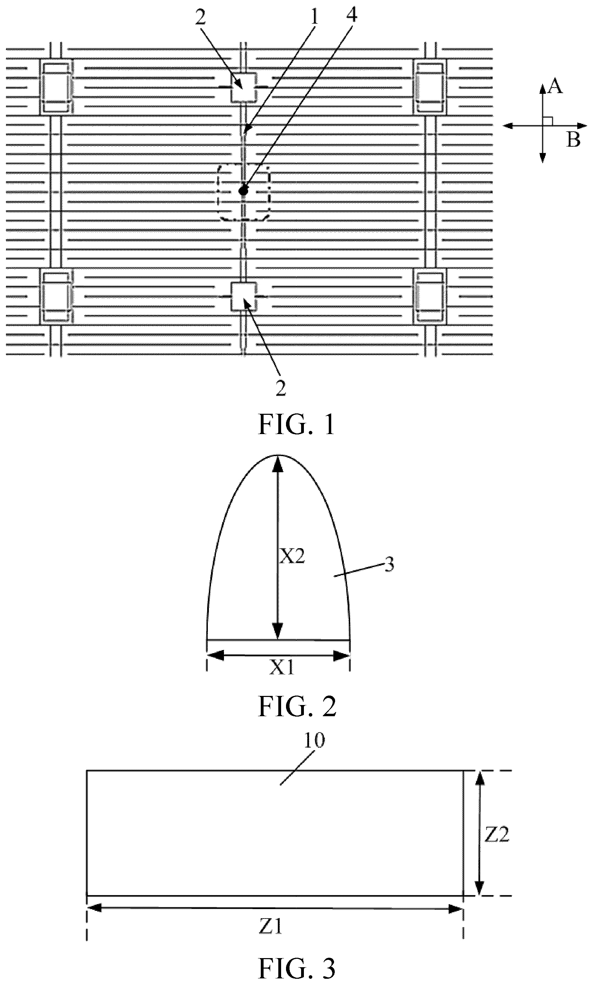

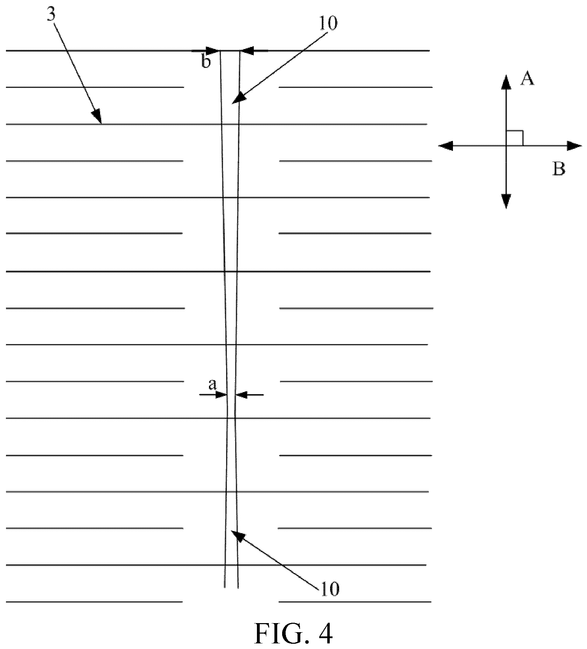

To solve the above-mentioned technical problems, in a first aspect, an embodiment of the present application provides a solar cell. Referring to FIG. 1 to FIG. 4, the solar cell includes a solar cell body, a plurality of busbars 1, a plurality of pads 2, and a plurality of collector electrodes 3. The plurality of busbars 1 are formed on the solar cell body, extend in a first direction A, and are distributed at intervals in a second direction B. The first direction is different from the second direction. For the busbars 1, the plurality of pads 2 are arranged on the busbars 1 at intervals in the first direction. For each of at least one of the plurality of busbars 1, in a direction from a preset point 4 on the busbar 1 to any one of the pads 2 adjacent to the preset point 4, a width of the busbar 1 gradually increases. The preset point 4 is any point between any two adjacent pads 2 on the busbar 1 on which the preset point is located, and a width direction of the busbar 1 is consistent with the second direction. A direction from the preset point 4 to any one of the pads 2 adjacent to the preset point 4 on the busbar on which the preset point is located is parallel to the first direction. The plurality of collector electrodes 3 are formed on the solar cell body, extend in the second direction, and are distributed at intervals in the first direction. Each of the busbars 1 intersects with a plurality of collector electrodes 3 with a same polarity. For each of the at least one busbars 1, Sz≥2×n×Sx, and n is an integer greater than or equal to 1. At least one busbar 1 located between the preset point 4 on the busbar 1 and any one of the pads 2 adjacent to the preset point 4 on the busbar is defined as a first busbar 10, and Sx represents a cross-sectional area, in the first direction, of any one of the collector electrodes 3 intersecting with the first busbar 10. For an n^{th} collector electrode 3 that intersects with the first busbar 10 starting from the preset point 4 on the busbar 1 and in a direction from the preset point 4 to the any one of the pads, Sz represents a cross-sectional area, in the second direction, of the first busbar 10 at a location at which the first busbar intersects with the n^{th} collector electrode 3.

The at least one busbar may be all or part of the plurality of busbars. In the present application, the width of the at least one busbar is set to be gradually varied to save a busbar material. On this premise, whether widths of all busbars or part of busbars are set to be gradually varied can be determined according to a specific situation. A typical example is that when both aluminum busbars and silver busbars are included, since silver is relatively expensive, the silver busbars can be designed to be gradually varied, that is, widths of silver busbars are set to be gradually varied, while aluminum is cheap and it is difficult to print an aluminum electrode, so that it is not necessary to make aluminum busbars gradually varied. A risk is caused if the aluminum busbars are gradually varied.

The structure, specification, and the like of the solar cell body can be set according to an actual situation, and are not specifically limited herein. Further, the first direction and the second direction may be any two directions parallel to a surface of the solar cell body and different from each other. In an embodiment, referring to FIG. 1, the first direction A and the second direction B are orthogonal.

Referring to FIG. 1 to FIG. 4, in an actual use process, the collector electrode 3 collects carriers generated in a corresponding region of the solar cell body, and the busbar 1 is configured to collect the carriers collected by the collector electrode 3 intersecting with the collector electrode. Then, the busbar 1 conveys the collected carriers to the pad 2, and the pad 2 conveys the carriers to a solder strip connected to the pad. As a quantity of collector electrodes 3 intersecting with the busbar 1 increases, a current density borne by the busbar 1 continuously increases. Based on this, when a width of the busbar 1 gradually increases in a direction from the preset point 4 to any one of the pads 2 adjacent to the preset point 4, an ability of the busbar 1 to bear a current density can be improved, so as to improve a current collection effect of the busbar 1, thereby ensuring performance of the solar cell. It should be understood that a minimum width of the busbar 1 in the embodiment of the present application meets actual operating requirements. In other words, compared with a medium-width busbar in the related art, the busbar 1 in the embodiment of the present application has a more proper width design.

Further, the width of the busbar 1 gradually increases in the direction from the preset point 4 to any one of the pads 2 adjacent to the preset point 4. In this case, in a case that it is ensured that a region of the busbar 1 connected to the pad 2 operates normally and a dimension of the pad 2 is substantially consistent or consistent with a dimension of a pad in the related art (in other words, a maximum width of the busbar 1 is substantially consistent or consistent with a width of a busbar in the related art, or even less than the width of the busbar in the related art), since the width of the busbar 1 away from the pad 2 gradually decreases, an amount of a slurry used to manufacture the busbar 1 is less than an amount of a slurry used to manufacture a busbar having a same width in the related art. Based on this, manufacturing costs of the busbar 1 can be reduced, thereby reducing manufacturing costs of the solar cell. In addition, compared with a medium-width busbar in the related art, the busbar 1 provided in the embodiment of the present application can further reduce blockage to the front of the solar cell body, so as to improve photoelectric conversion efficiency of the solar cell. Further, due to the characteristics that a single busbar 1 needs to collect a current from collector electrodes 3 located on a left side and a right side of the busbar, a region with lower resistance is preferentially selected for conduction. Therefore, when Sz≥2×n×Sx, it can be ensured that the busbar 1 has optimal current conduction performance when collecting a current.

In a possible implementation, referring to FIG. 2, Sx is greater than or equal to 75 µm² and less than or equal to 375 µm². For example, Sx may be 75 µm², 95 µm², 124 µm², 150 µm², 196 µm², 260 µm², 375 µm², or the like. X1 is greater than or equal to 30 µm and less than or equal to 50 µm, where X1 represents a width of any one of the collector electrodes 3 intersecting with the first busbar 10, and a width direction of the collector electrode 3 is consistent with the first direction. For example, X1 may be 30 µm, 33 µm, 35 µm, 40 µm, 42 µm, 48 µm, 50 µm, or the like. A value of X1 is related to a specification of a screen for printing, and a screen line width can be adjusted according to different mass production requirements. In this case, in a case that an ability of the collector electrode 3 to collect carriers is ensured, manufacturing costs of the collector electrode 3 can be reduced, thereby further reducing manufacturing costs of the solar cell.

In a possible implementation, a cross-sectional shape of the collector electrode can be set according to actual requirements, and for example, may be triangular or quasi-triangular. Specifically, in a case that the cross-sectional shape is quasi-triangular, it means that a bottom edge of the cross section is a straight line segment, and remaining edge portions of the cross section that are connected to two ends of the straight line segment are arc segments.

Referring to FIG. 2, in the embodiment of the present application, the cross-sectional shape of the collector electrode 3 is quasi-triangular. For example, the cross-sectional area of the collector electrode 3 is Sx=f×((X1×X2)/2), where f denotes an empirical coefficient and is used for correcting an actual cross-sectional area of the collector electrode 3. It should be understood that f is affected by different machine platforms, slurries, a printing state of a screen accessory, and other factors. f is greater than 0 and less than or equal to 2. For example, f may be 0.1, 0.5, 1, 1.2, 1.6, 2, or the like. X2 represents a height of any one of the collector electrodes 3 intersecting with the first busbar 10, and a height direction of the collector electrode 3 is perpendicular to both the first direction and the second direction. A value of X2 is related to a specification of a screen for printing, and a screen thickness can be adjusted according to different mass production requirements. For example, X2 is greater than or equal to 5 µm and less than or equal to 15 µm. For example, X2 may be 5 µm, 8 µm, 9 µm, 10 µm, 12 µm, 13 µm, 15 µm, or the like.

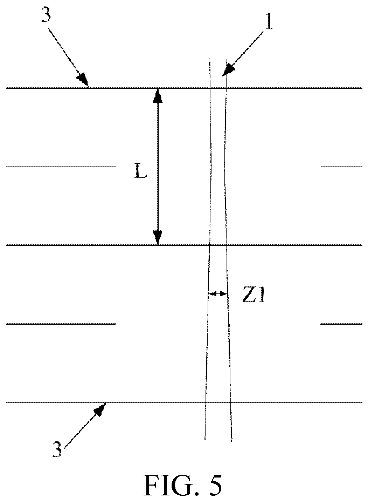

In a possible implementation, referring to FIG. 5, a distance L between adjacent collector electrodes 3 with the same polarity can be set according to an actual situation, and is not specifically limited herein. The distance is in the first direction. For example, the distance is only related to a graphic design, and once a graphic is determined, the distance is a fixed value.

In a possible implementation, referring to FIG. 1 to FIG. 5, a width Z1 of the first busbar 10 is greater than or equal to a and less than or equal to b, where a is less than b. Both a and b may be constants. For example, a is greater than or equal to 30 µm and less than or equal to 200 µm; and b is greater than or equal to 60 µm and less than or equal to 3 mm. For example, Z1 may be 30 µm, 56 µm, 60 µm, 200 µm, 2500 µm, 3000 µm, or the like. Correspondingly, a may be 30 µm, 45 µm, 56 µm, 80 µm, 130 µm, 200 µm, or the like, and b may be 60 µm, 80 µm, 160 µm, 1000 µm, 2500 µm, 3000 µm, or the like.

In a case that the above-mentioned technical solution is adopted, the value of the width of the first busbar 10 can be selected by comprehensively considering the cross-sectional area of the collector electrode 3 intersecting with the first busbar, a height of the first busbar 10, or other influencing factors. In this case, not only selectivity of the width of the first busbar 10 is increased, but also the application range of the first busbar 10 can be expanded.

In a possible implementation, a cross-sectional shape of the first busbar can be set according to actual requirements, and for example, may be rectangular, quasi-rectangular, square, quasi-square, or the like. Specifically, in a case that the cross-sectional shape is quasi-rectangular or quasi-square, it means that a bottom edge of the cross section is a straight line segment, and remaining edge portions of the cross section that are connected to two ends of the straight line segment are arc segments, and an edge portion of the cross section opposite to the straight line segment is an arc segment.

Referring to FIG. 3, in the embodiment of the present application, the cross-sectional shape of the first busbar 10 is rectangular. For example, the cross-sectional area of the first busbar 10 is Sz=Z1×Z2, where Z2 represents a height of the first busbar 10, and a height direction of the first busbar 10 is perpendicular to both the first direction and the second direction. A value of Z2 is related to a specification of a screen for printing, and a screen thickness can be adjusted according to different mass production requirements. For example, Z2 is greater than or equal to 2 µm and less than or equal to 7 µm. For example, Z2 may be 2 µm, 2.5 µm, 3.6 µm, 4.9 µm, 5 µm, 6.2 µm, 6.8 µm, 7 µm, or the like.

In a possible implementation, referring to FIG. 1, the preset point 4 is a central point between any two adjacent pads 2 on the busbar 1 on which the preset point is located.

The following describes a process of calculating the value of the width of the first busbar with a possible case as an example. It should be understood that the following description is only for understanding, not for a specific limitation.

Referring to FIG. 1 to FIG. 4, when the cross-sectional area Sx of the collector electrode 3 is 180 µm², the height Z2 of the first busbar 10 is 4.5 µm, and the preset point 4 is a central point between two adjacent pads 2 on the busbar 1 on which the preset point is located. There are 10 collector electrodes 3 between the two pads 2. When the fifth collector electrode 3 passes through the central point, a=(2×1×180)/4.5=80 µm, and b=(2×5×180)/4.5=400 µm. That is, a width Z1 of the first busbar 10 is greater than or equal to 80 µm and less than or equal to 400 µm.

It should be understood that in an actual manufacturing process, it cannot be ensured that a collector electrode passes through the preset point every time, but it can be ensured that there is inevitably a collector electrode around the preset point. Therefore, when a minimum value of the width of the first busbar is calculated, if no collector electrode passes through the preset point, a collector electrode closest to the preset point is selected for calculation.

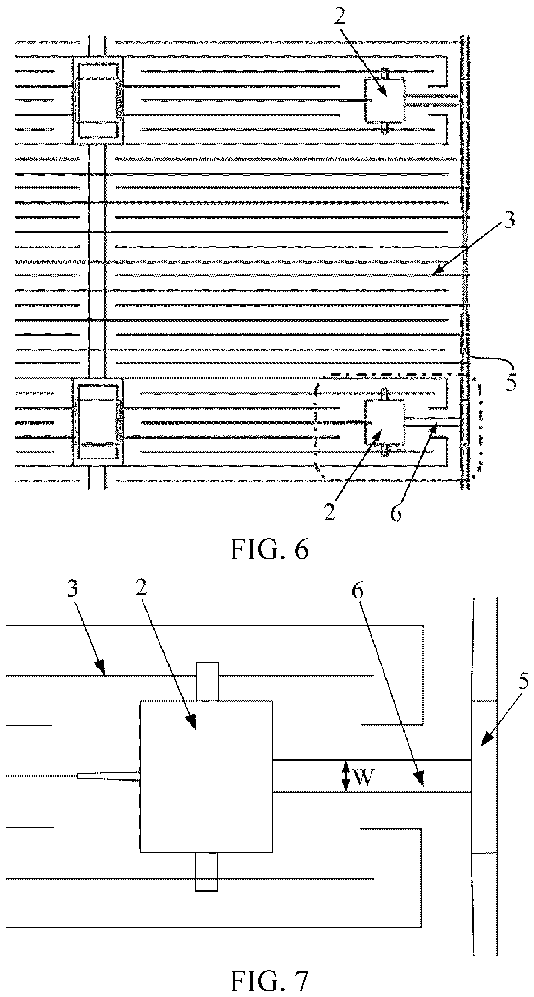

In a possible implementation, referring to FIG. 6 and FIG. 7, for a busbar 1 close to the edge of the solar cell body (referred to as a second busbar 5 for ease of description), collector electrodes 3 with the same polarity are arranged at intervals in the first direction on only one side of the busbar facing the adjacent busbar 1 (that is, the busbar 1 adjacent to the busbar 1 close to the edge of the solar cell body). In this case, manufacturing costs of the collector electrode 3 can be reduced.

Referring to FIG. 6 and FIG. 7, the solar cell further includes a lap busbar 6. One end of the lap busbar 6 is connected to the busbar 1 close to the edge of the solar cell body, and the pad 2 is arranged at the other end of the lap busbar 6. The lap busbar 6 is located between the busbar 1 close to the edge of the solar cell body and the busbar 1 adjacent to the busbar 1 close to the edge of the solar cell body. In this case, connectivity between the pad 2 and the busbar 1 close to the edge of the solar cell body can be ensured to ensure performance of the solar cell.

In an embodiment, the width of the busbar 1 close to the edge of the solar cell body is less than the width of a corresponding region of the adj acent busbar 1 (namely the busbar 1 adjacent to the busbar 1 close to the edge of the solar cell body). That is, at any position in the first direction, the width of the busbar 1 close to the edge of the solar cell body is less than the width of the adjacent busbar 1. Since the collector electrode 3 intersecting with the busbar is arranged on only one side of the busbar 1 close to the edge of the solar cell body, the width of the busbar 1 can be reduced compared with the width of the corresponding region of the adjacent busbar 1. Based on this, while the ability of the busbar 1 close to the edge of the solar cell body is ensured, manufacturing costs of the busbar 1 can be reduced, thereby reducing manufacturing costs of the solar cell.

In an embodiment, a width of the busbar 1 close to the edge of the solar cell body is 1/2 that of a corresponding region of the adjacent busbar 1.

In an embodiment, a projection of the busbar 1 close to the edge of the solar cell body on the solar cell body includes a trapezoid and/or a triangle.

In a case that the above-mentioned technical solution is adopted, the selectivity is increased in a condition that the cross-sectional area of the busbar 1 close to the edge of the solar cell body meets actual requirements. In this case, the busbar 1 can be adapted to different application scenarios to expand the application range of the solar cell.

For example, the projection of the busbar 1 close to the edge of the solar cell body on the solar cell body may include only a trapezoid or only a triangle, or certainly, may include both a trapezoid and a triangle.

In an embodiment, referring to FIG. 7, a projection of the lap busbar 6 on the solar cell body is rectangular.

In an embodiment, referring to FIG. 7, a width W of the lap busbar 6 is equal to a maximum value of a width of the busbar 1 connected to the lap busbar 6 (namely a maximum value of Z1), and a width direction of the lap busbar 6 is consistent with the first direction. In this case, not only the ability of the lap busbar 6 to collect all carriers collected by the collector electrode 3 can be ensured, but also the ability of the lap busbar 6 to transmit the collected current to the pad 2 can be ensured, so as to ensure performance of the solar cell.

In a possible implementation, the solar cell is a back contact solar cell, and the busbar is an N-region busbar.

The N-region busbar is usually made of silver paste, and silver has a high unit price. Therefore, when the busbar provided by the present application is an N-region busbar of a back contact solar cell, manufacturing costs of the busbar can be reduced while the performance of the busbar is ensured, so as to reduce the manufacturing costs of the solar cell.

In a second aspect, an embodiment of the present application further provides a solar module. The solar module includes the solar cell according to the above-mentioned technical solution.

Compared with the related art, the solar module according to the embodiment of the present application has the same beneficial effects as the beneficial effects of the solar cell in the above-mentioned technical solution, and details are not described herein.

In a possible implementation, the solar module further includes a solder strip. The solder strip is arranged on a pad in a first direction.

In description of the above-mentioned implementation, specific features, structures, materials, or characteristics may be combined in any one or more embodiments or examples in a proper manner.

The foregoing descriptions are merely specific implementations of the present application, but the protection scope of the present application is not limited thereto. Any variation or replacement readily figured out by a person skilled in the art within the technical scope disclosed in the present application shall fall within the protection scope of the present application. Therefore, the protection scope of the present application shall be subject to the protection scope of the appended claims.

## Claims

1. A solar cell, comprising:
a solar cell body;
a plurality of busbars formed on the solar cell body, extending in a first direction, and distributed at intervals in a second direction, the first direction being different from the second direction;
a plurality of pads, for at least one of the plurality of busbars, the plurality of pads being arranged on the at least one busbar at intervals in the first direction; in a direction from a preset point on the at least one busbar to any one of the pads adjacent to the preset point on the busbar on which the preset point is located, a width of the busbar on which the preset point is located gradually increasing; the preset point being any point between any two adjacent pads on the busbar on which the preset point is located; a width direction of the at least one busbar being consistent with the second direction, and a direction from the preset point to any one of the pads adjacent to the preset point on the busbar on which the preset point is located being parallel to the first direction; and
a plurality of collector electrodes formed on the solar cell body, extending in the second direction, and distributed at intervals in the first direction, each of the busbars intersecting with a plurality of collector electrodes with a same polarity,
wherein Sz≥2×n×Sx, and n is an integer greater than or equal to 1; at least one busbar located between the preset point and any one of the pads that is on the busbar on which the preset point is located and that is adjacent to the preset point is defined as a first busbar; Sx represents a cross-sectional area, in the first direction, of any one of the collector electrodes intersecting with the first busbar; and for an n^{th} collector electrode that intersects with the first busbar starting from the preset point on the busbar and in a direction from the preset point to the any one of the pads, Sz represents a cross-sectional area, in the second direction, of the first busbar at a location at which the first busbar intersects with the n^{th} collector electrode.

2. The solar cell according to claim 1, wherein
Sx is greater than or equal to 75 µm² and less than or equal to 375 µm²; and
X1 is greater than or equal to 30 µm and less than or equal to 50 µm,
wherein X1 represents a width of any one of the collector electrodes intersecting with the first busbar, and a width direction of the collector electrode is consistent with the first direction.

3. The solar cell according to claim 1 or 2, wherein
a width Z1 of the first busbar is greater than or equal to a and less than or equal to b,
wherein a is less than b; a is greater than or equal to 30 µm and less than or equal to 200 µm; and b is greater than or equal to 60 µm and less than or equal to 3 mm.

4. The solar cell according to claim 1, wherein for the busbar close to an edge of the solar cell body, the collector electrodes having the same polarity are arranged at intervals in the first direction only on a side of the busbar that faces an adjacent busbar; and
the solar cell further comprises a lap busbar, one end of the lap busbar being connected to the busbar close to the edge of the solar cell body, and the pad being arranged at the other end of the lap busbar; and the lap busbar being located between the busbar close to the edge of the solar cell body and the busbar adjacent to the busbar close to the edge of the solar cell body.

5. The solar cell according to claim 4, wherein at any position in the first direction, a width of the busbar close to the edge of the solar cell body is less than a width of a corresponding region of the adjacent busbar.

6. The solar cell according to claim 4 or 5, wherein at any position in the first direction, the width of the busbar close to the edge of the solar cell body is 1/2 that of the corresponding region of the adjacent busbar.

7. The solar cell according to claim 4, wherein a projection of the busbar close to the edge of the solar cell body on the solar cell body comprises a trapezoid and/or a triangle.

8. The solar cell according to claim 4, wherein a width of the lap busbar is equal to a maximum value of a width of the busbar connected to the lap busbar; and a width direction of the lap busbar is consistent with the first direction.

9. The solar cell according to claim 1, wherein
the solar cell is a back contact solar cell, and the busbar is an N-region busbar; and/or
the preset point is a central point between any two adjacent pads on the busbar on which the preset point is located.

10. A solar module, comprising the solar cell according to any one of claims 1 to 9.
